# EUROPEAN PATENT APPLICATION

(11) **EP 0 584 786 A1**
(43) Date of publication of application: **02.03.1994**
(21) Application number: 93113496.9
(22) Date of filing: 24.08.1993
(51) Int. Cl.: G06G 7/14, G01R 19/00

(54) **Averaging circuit**

(30) Priority: 25.08.1992 JP 248690/92
(71) Applicant: YOZAN INC., Tokyo 155 (JP); SHARP KABUSHIKI KAISHA, Osaka 545 (JP)
(72) Inventor: Shou, Guoliang, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

It purposes to provide a small type and high speed averaging circuit.

An averaging circuit has a plurality of CMOSs with substantially equal characteristics, their voltage follower outputs are connected to a common output. A mean value is generated at the common output of input voltage of CMOSs.

## Description

### FIELD OF THE INVENTION

This invention relates to an averaging circuit for outputting a mean value of a plural number of inputs.

### BACKGROUND OF THE INVENTION

Conventionally, a complicated calculation such as a calculation of a mean value of a plural number of data is realized by digital computer, and a lot of circuits are necessary including summation circuits, registers and a substraction circuits. Since substraction circuit cannot be of high speed, the process speed is limited.

### SUMMARY OF THE INVENTION

This invention is invented so as to solve the above problems and it purposes to provide a small sized and high speed averaging circuit.

An averaging circuit according to the present invention has CMOSs, the voltage follower outputs thereof are connected to a common output, so that a mean value of inputs of the CMOSs is generated.

### BRIEF DESCRIPTION OF THE DRAWINGS

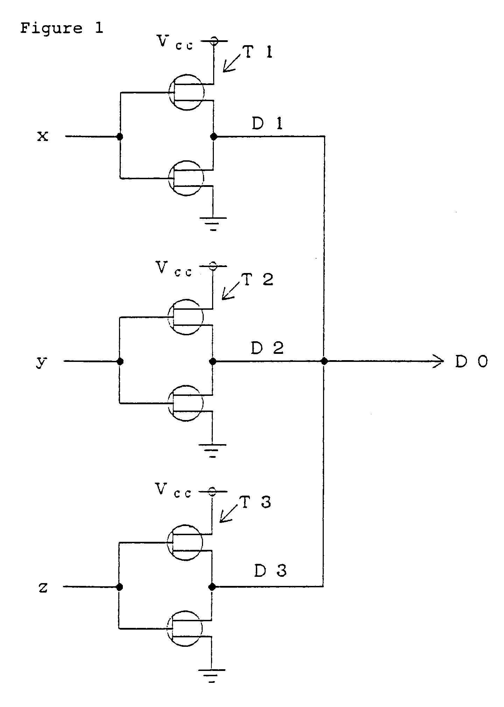

Figure 1 is a circuit diagram showing an embodiment of an averaging circuit according to the present invention.

### PREFERRED EMBODIMENT OF THE PRESENT INVENTION

Hereinafter an embodiment of an averaging circuit according to this invention is described with reference to the attached drawings.

In Figure 1, a averaging circuit includes a plural number of CMOSs (shown by reference T1, T2 and T3) in parallel, and input voltages x, y and z are inputted to T1, T2 and T3. T1, T2 and T3 have voltage follower outputs D1, D2 and D3 and these outputs are connected to a common output DO. Each CMOS has substantially equal characteristics to one another and the independent characteristics of each CMOS are defined as followings:

${\text{D1 = x - (V}}_{\text{tp}} {\text{+ V}}_{\text{tu}} \text{) / 2}$
${\text{D2 = y - (V}}_{\text{tp}} {\text{+ V}}_{\text{tu}} \text{) / 2}$
${\text{D3 = z - (V}}_{\text{tp}} {\text{+ V}}_{\text{tu}} \text{) / 2}$
${\text{V}}_{\text{tp}} \text{is a threshold voltage of pMOS.}$
${\text{V}}_{\text{tn}} \text{is a threshold voltage of nMOS.}$

If pMOS and nMOS of the CMOS are enhancement type, (Vₜₚ + Vₜₙ) has a positive value and an effect voltage exists unpreferably for a mean value calculation. So, depression type pMOS and nMOS are applied to the CMOS.

By connecting the outputs of these CMOSs, a stable point of each CMOS becomes an output voltage for the common output, and as the result,

${\text{DO = (x + y + z) / 3 - (V}}_{\text{tp}} {\text{+ V}}_{\text{tu}} \text{) / 2.}$

That is, the common output DO is a subtraction result of a mean value of a threshold voltage from a mean value of input voltages x, y and z. The common output represents a mean value, however, when Vtp and Vtn are adjusted to O[V] by designing each CMOS for the specification, a characteristics of $\text{DO = (x + y + z) / 3}$ can be obtained.

As mentioned above, the embodiment includes 3 CMOSs connected in parallel, however, a mean value corresponding to 2 or more than 3 inputs can be outputted by connecting 2 or more than 3 CMOSs similarly. In the case that the offset voltage is useful, the enhancement type pMOS and nMOS are applied.

The time for obtaining these outputs is almost the same as response time of 1 CMOS, and the calculation speed is much higher than that of digital circuit. As shown by the circuit in the embodiment, the size of circuit is very small.

An averaging circuit according to this invention has advantages of a small size and high responding speed, because a mean value of inputs of CMOSs is generated on the common output, by connecting a voltage follower output of CMOSs to the common output of CMOS.

## Claims

1. An averaging circuit comprising;
i) a plural number of CMOSs with substantially equal characteristics to one another connected to a common output at a voltage follower output of each CMOS; and
ii) an input voltage connected to a gate of each CMOS.

2. An averaging circuit as claimed in Claim 1, wherein said CMOS is of depression type.
